# EUROPÄISCHE PATENTSCHRIFT

(11) **EP 2 619 810 B1**
(45) Veröffentlichungstag und Bekanntmachung des Hinweises auf die Patenterteilung: **19.08.2015**
(21) Anmeldenummer: 11745979.2
(22) Anmeldetag: 19.08.2011
(51) Int. Cl.: H01L 33/54, H01L 33/56, H01L 33/58

(54) **ELEKTRONISCHES BAUELEMENT**
ELECTRONIC COMPONENT
COMPOSANT ÉLECTRONIQUE

(30) Priorität: 21.09.2010 DE 102010046122
(43) Veröffentlichungstag der Anmeldung: 31.07.2013
(73) Patentinhaber: OSRAM Opto Semiconductors GmbH, 93055 Regensburg (DE)
(72) Erfinder: RAMCHEN, Johann, 84032 Altdorf (DE); KEITH, Christina, 93073 Neutraubling (DE); BRAUNE, Bert, 93173 Wenzenbach (DE)
(74) Vertreter: Epping - Hermann - Fischer
(86) Internationale Anmeldenummer: PCT/EP2011/064296
(87) Internationale Veröffentlichungsnummer: WO 2012/038164

(56) Entgegenhaltungen:
- WO-A1-2008/018336
- DE-A1-102007 015 474
- JP-A- 2006 179 544
- JP-A- 2008 034 546
- US-A1- 2007 182 323
- US-A1- 2008 068 845
- US-A1- 2010 102 461
- "Technical Data Sheet for NT-300H epoxy resin", , 6 September 2001 (2001-09-06), pages 1-5, XP055130982, Internet Retrieved from the Internet: URL:https://www.nitto.co.jp/product/indust ry/electronics/nt_pdf/NT300H_J.pdf [retrieved on 2014-07-22]

## Beschreibung

Es wird ein elektronisches Bauelement angegeben.

Diese Patentanmeldung beansprucht die Priorität der deutschen Patentanmeldung 10 2010 046 122.9, deren Offenbarungsgehalt hiermit durch Rückbezug aufgenommen wird.

Wird ein Halbleiterbauelement wie etwa eine Licht emittierende Diode (LED) mittels eines Lötprozesses auf einem Träger wie etwa einer Leiterplatte befestigt, so ist die LED sowie seine Komponenten durch die für das Löten erforderliche Erwärmung und das anschließende Abkühlen thermomechanischen Spannungen ausgesetzt. Weist die LED beispielsweise ein Gehäuse auf, das mehrere verschiedene Kunststoffteile umfasst, in denen ein Halbleiterchip angeordnet ist, so können die thermomechanischen Spannungen im Gehäuse derart auf den Halbleiterchip wirken, dass dieser von einer Montagefläche abgelöst oder abgehoben wird. Dies kann zu einem Ausfall der LED führen. Bei Bauteilen, die beispielsweise zusätzlich zu einem den Halbleiterchip einbettenden Material darüber eine Abdeckung aufweisen, wird das thermische Ungleichgewicht beim Aufwärmen beziehungsweise Abkühlen und damit die thermomechanischen Spannungen sogar noch verstärkt, wodurch auch die Ausfallwahrscheinlichkeit für derartige Bauelemente steigt.

Um einem derartigen Effekt entgegenzutreten, kann beispielsweise die Haftung des Halbleiterchips auf der Montagefläche durch einen Kleber mit einer erhöhten adhäsiven Leistung erreicht werden. Weiterhin können Kunststoffmaterialien, insbesondere Vergussmaterialien, verwendet werden, die einen geringen Elastizitätsmodul weisen, so beispielsweise ein Silikonverguss. Weiterhin ist es auch möglich, die thermomechanischen Spannungen durch eine Anpassung beziehungsweise Optimierung der Gehäusegeometrie zu verringern. Weiterhin kann auch versucht werden, den Kleber, mit dem der Halbleiterchip auf dem Montagebereich montiert ist, vom Vergussmaterial zu entkoppeln, beispielsweise durch eine geeignete Form der Klebstoffkehlen.

All diese Maßnahmen haben jedoch eine zum Teil erhebliche Vergrößerung des Aufwands zur Herstellung des Halbleiterbauelements zur Folge.

Die Druckschrift JP 2006-179544 A beschreibt eine LED-Lichtquelle mit einem Substrat, auf dem ein Reflektor mit einer Vielzahl von Vertiefungen angeordnet ist. In den Vertiefungen ist jeweils ein LED-Chip montiert, der mit einer ersten Harzschicht aus Silikon, einer zweiten Harzschicht aus einem Epoxid und einer dritten Harzschicht ebenfalls aus einem Epoxid bedeckt ist, wobei das Material der dritten Harzschicht eine Glasübergangstemperatur aufweist, die nicht kleiner als die Glasübergangstemperatur der zweiten Harzschicht ist.

Die Druckschrift US 2007/0182323 A1 beschreibt ein Licht emittierendes Bauelement mit einem Licht emittierenden Element auf einem Substrat und umgeben von einer Reflektorplatte, die auf dem Substrat montiert ist. Die Reflektorplatte weist eine Vertiefung auf, in der das Licht emittierende Element angeordnet ist. Das Licht emittierende Element ist unmittelbar bedeckt durch eine erste Verkapselungsschicht aus Silikon, auf der wiederum eine zweite Verkapselungsschicht aus einem Epoxid aufgebracht ist, die die Vertiefung in der Reflektorplatte füllt. Eine dritte Verkapselungsschicht aus einem Epoxid bedeckt die zweite Verkapselungsschicht und die Reflektorplatte. Die Glasübergangstemperatur der zweiten Verkapselungsschicht ist so gewählt, dass bei Temperaturänderungen möglichst keine Risse in den Schichten entstehen.

Zumindest eine Aufgabe von bestimmten Ausführungsformen ist es, ein elektronisches Bauelement mit einem Halbleiterchip anzugeben, bei dem die Gefahr einer Ablösung des Halbleiterchips bei einem Lötvorgang verringert werden kann.

Diese Aufgabe wird durch einen Gegenstand mit den Merkmalen des unabhängigen Patentanspruchs gelöst. Vorteilhafte Ausführungsformen und Weiterbildungen des Gegenstands sind in den abhängigen Ansprüchen gekennzeichnet und gehen weiterhin aus der nachfolgenden Beschreibung und den Zeichnungen hervor.

Ein elektronisches Bauelement weist gemäß zumindest einer Ausführungsform einen Gehäusekörper mit einer Vertiefung auf. In der Vertiefung ist ein Halbleiterchip angeordnet. Der Gehäusekörper kann insbesondere vorgeformt sein. Das bedeutet, dass vor Montage des Halbleiterchips der Gehäusekörper mittels eines Formprozesses wie etwa Spritzgießen, Spritzpressen oder Formpressen aus einem geeigneten Material, beispielsweise einem Thermoplast, ausgeformt wird. Das Thermoplast kann beispielsweise Polyphthalamid (PPA) oder auch ein anderes geeignetes Kunststoffmaterial aufweisen.

Weiterhin kann das Bauelement einen Leiterrahmen aufweisen, der in den Gehäusekörper eingebettet ist. Der Leiterrahmen kann insbesondere mit dem Material des Gehäusekörpers umformt sein und einen Montagebereich für den Halbleiterchip bereitstellen. Weiterhin kann der Leiterrahmen. Kontaktbereiche außerhalb des Gehäusekörpers für das elektronische Bauelement bereitstellen, mittels derer das elektronische Bauelement auf einem Träger beispielsweise einer Leiterplatte mittels eines Lötprozesses befestigt und elektrisch angeschlossen werden kann.

Weiterhin kann der Halbleiterchip mittels eines Verbindungsmaterials auf dem Leiterrahmen angeordnet und damit montiert sein. Das Verbindungsmaterial kann beispielsweise ein elektrisch leitender Klebstoff, der auch als so genannter Chipkleber bezeichnet werden kann, aufweisen oder sein. Alternativ dazu kann das Verbindungsmaterial auch ein Lot aufweisen oder sein. Für eine zuverlässige Funktion des elektronischen Bauelements kann es erforderlich sein, dass der Halbleiterchip mittels des Verbindungsmaterials dauerhaft am Leiterrahmen befestigt und elektrisch an diesen angeschlossen ist.

Weiterhin kann das elektronische Bauelement oberflächenmontierbar sein. Das kann insbesondere bedeuten, dass der Leiterrahmen derart ausgebildet ist, dass er auf einer Außenseite des Gehäusekörpers oberflächenmontierbare Kontaktbereiche bereitstellt.

Gemäß einer weiteren Ausführungsform ist der Halbleiterchip ein optoelektronischer Halbleiterchip. Dabei kann der Halbleiterchip insbesondere als Licht emittierender oder als Licht empfangender Halbleiterchip ausgebildet sein. Entsprechend dem gewünschten Wellenlängenbereich des vom Halbleiterchip abgestrahlten beziehungsweise empfangenen Lichts kann der Halbleiterchip beispielsweise als Epitaxieschichtenfolge, das bedeutet als epitaktisch gewachsene Halbleiterschichtenfolge, basierend auf einem Arsenid-, Phosphid- oder Nitrid-Verbindungshalbleitermaterialsystem ausgebildet sein. Derartige Halbleiterchips sind dem Fachmann bekannt und werden hier nicht weiter ausgeführt. Alternativ dazu kann der Halbleiterchip beispielsweise auch als Transistor oder als integrierter Schaltkreis oder als Kombination der genannten Halbleiterchips ausgeführt sein.

Gemäß einer weiteren Ausführungsform ist in der Vertiefung des Gehäusekörpers ein Verguss aus einem ersten Kunststoffmaterial angeordnet, in den der Halbleiterchip eingebettet ist. Das kann insbesondere bedeuten, dass der Verguss an den Halbleiterchip beispielsweise an allen Oberflächenbereichen, an denen nicht das Verbindungsmaterial angeordnet ist, direkt an den Halbleiterchip angrenzt. Dadurch steht der Halbleiterchip in direktem Kontakt mit dem Verguss. Thermomechanische Spannungen, die im Verguss auftreten können, können somit direkt auf den Halbleiterchip wirken.

Ist der Halbleiterchip beispielsweise als optoelektronischer Halbleiterchip und insbesondere als Licht emittierender Halbleiterchip ausgeführt, so kann das Kunststoffmaterial des Vergusses transparent ausgeführt sein. Weiterhin kann der Verguss beispielsweise auch einen in das erste Kunststoffmaterial eingebetteten Wellenlängenkonversionsstoff und/oder Streupartikel aufweisen.

Gemäß einer weiteren Ausführungsform ist über der Vertiefung ein Abdeckelement aus einem zweiten Kunststoffmaterial angeordnet. Das Abdeckelement kann zum Schutz des Vergusses beziehungsweise des Halbleiterchips auf dem Verguss angeordnet sein. Weiterhin kann das Abdeckelement auch zusätzliche Funktionalitäten für das elektronische Bauelement bereitstellen. Ist der Halbleiterchip als optoelektronischer Halbleiterchip und insbesondere als lichtemittierender Halbleiterchip ausgeführt, so kann das Abdeckelement beispielsweise als optisches Element ausgeführt sein, insbesondere beispielsweise als Linse. Dazu kann mit Vorteil das zweite Kunststoffmaterial des Abdeckelements transparent sein, wobei es auch möglich sein kann, dass in das zweite Kunststoffmaterial ein Wellenlängenkonversionsstoff und/oder Streupartikel eingebettet sind.

Das Abdeckelement kann insbesondere mittels eines Klebstoffs auf dem Verguss angeordnet sein. Das kann insbesondere bedeuten, dass das Abdeckelement mittels des Klebstoffs auf dem Verguss befestigt ist. Der Klebstoff kann dabei ein gleiches Material oder zumindest gleiche Materialklasse wie das erste Kunststoffmaterial des Vergusses oder des zweiten Kunststoffmaterials des Abdeckelements aufweisen. Besonders bevorzugt kann der Klebstoff ein Epoxidkleber sein, der weiterhin in einer dünnen Schicht zwischen dem Abdeckelement und dem Verguss angeordnet ist und den Verguss mit dem Abdeckelement dauerhaft verbindet. Besonders bevorzugt kann der Klebstoff gleiche Eigenschaften, insbesondere eine gleiche Glasübergangstemperatur, wie das Abdeckelement aufweisen. Mit anderen Worten kann der Klebstoff ein Kunststoffmaterial, beispielsweise das zweite Kunststoffmaterial, mit der zweiten Glasübergangstemperatur aufweisen.

Gemäß einer weiteren Ausführungsform weist das erste Kunststoffmaterial eine erste Glasübergangstemperatur auf, während das zweite Kunststoffmaterial eine zweite Glasübergangstemperatur aufweist. Die zweite Glasübergangstemperatur ist dabei kleiner als die erste Glasübergangstemperatur. Die Glasübergangstemperatur ist diejenige Temperatur, bei der das erste beziehungsweise das zweite Kunststoffmaterial eine wesentliche Änderung in seiner Verformungsfähigkeit aufweist. Unterhalb der Glasübergangstemperatur kann das erste beziehungsweise zweite Kunststoffmaterial eine geringe Verformbarkeit und ein eher sprödes Verhalten aufweisen, während für Temperaturen oberhalb der Glasübergangstemperatur die Verformbarkeit durch ein eher weiches, plastisch verformbares Verhalten gekennzeichnet sein kann. Das kann insbesondere auch bedeuten, dass oberhalb der Glasübergangstemperatur das erste beziehungsweise zweite Kunststoffmaterial jeweils einen geringen Elastizitätsmodul aufweist, während unterhalb der Glasübergangstemperatur der jeweilige Elastizitätsmodul groß ist. Weiterhin können sich auch die thermischen Ausdehnungskoeffizienten oberhalb und unterhalb der Glasübergangstemperatur signifikant unterscheiden.

Gemäß einer weiteren Ausführungsform weisen das erste und das zweite Kunststoffmaterial jeweils ein Duroplast auf.

Beispielsweise können das erste und/oder das zweite Kunststoffmaterial ein Epoxid und/oder ein Acrylat aufweisen. Besonders vorteilhaft ist es, wenn sowohl das erste als auch das zweite Kunststoffmaterial jeweils ein Epoxidharz aufweisen. Durch unterschiedliche Additive und/oder durch unterschiedliche Vernetzungsgrade im ersten und zweiten Kunststoffmaterial können diese jeweils die oben genannte erste und zweite Glasübergangstemperatur aufweisen.

Bei bekannten elektronischen Bauelementen werden üblicherweise für ein Vergussmaterial und ein Abdeckmaterial Kunststoffmaterialien mit der gleichen oder zumindest annähernd der gleichen Glasübergangstemperatur eingesetzt. Wird ein derartiges bekanntes elektronisches Bauelement aufgelötet, so erfahren die einzelnen Elemente eines solchen Bauelements zumindest beim Abkühlvorgang nach dem Löten deutliche Temperaturunterschiede. Während auf der Oberfläche des Bauelements sehr rasch die Temperatur der Umgebung erreicht wird, befinden sich die inneren Komponenten eines solchen Bauelements, also beispielsweise der Verguss und der Halbleiterchip, noch auf einer höheren Temperatur. Da Kunststoffmaterialien wie beispielsweise Duroplaste beim Abkühlvorgang oberhalb der Glasübergangstemperatur einen starken Schrumpf erleiden, während sie unterhalb der Glasübergangstemperatur eine wesentlich geringere temperaturabhängige Ausdehnungsänderung aufweisen, und da sich wie oben beschrieben die Elastizitätsmoduln oberhalb und unterhalb der Glasübergangstemperatur deutlich unterscheiden, kann es beim Abkühlen dazu kommen, dass sich die weiter außen liegenden Elemente oder Bereich davon, beispielsweise also ein Abdeckelement und insbesondere dessen Oberseite, bereits unterhalb der Glasübergangstemperatur befindet und somit im Wesentlichen starr ist, während Elemente im Inneren des Bauelements wie etwa das Vergussmaterial noch oberhalb der Glasübergangstemperatur liegen und damit beim weiteren Abkühlen noch stärker schrumpfen. Dadurch, dass das Abdeckmaterial schon erstarrt ist und zumindest im Bereich der Oberfläche eine feste Form eingenommen hat, kann sich der Schrumpfungsschwerpunkt des Gesamtsystems aus Abdeckmaterial und Vergussmaterial in Richtung zum Abdeckmaterial verlagern, so dass zwischen dem Vergussmaterial und dem Halbleiterchip sowie zwischen dem Vergussmaterial und dem Gehäusekörper Zugspannungen aufgebaut werden, die oft die Adhäsionskräfte eines Verbindungsmaterials übersteigen, mit dem der Halbleiterchip im Gehausekörper montiert ist. Somit kann es bei bekannten Bauelementen, bei denen Materialien mit im Wesentlichen gleichen Glasübergangstemperaturen verwendet werden, leicht zur Delamination des Halbleiterchips kommen.

Im Gegensatz zu bekannten elektronischen Bauelementen kann beim hier beschriebenen elektronischen Bauelement der Zeitpunkt, bei dem das Abdeckelement erstarrt, verzögert werden, so dass das Abdeckelement während eines Abkühlvorgangs länger in einem elastischen und verformbaren Zustand bleibt. Schrumpfungen, die im Verguss durch die verzögerte Abkühlung stattfinden, können somit durch das Abdeckelement länger ausgeglichen werden. Dadurch können mit Vorteil thermoelastische Spannungen, die in nachteiliger Weise auf den Halbleiterchip wirken können, verringert werden. Besonders bevorzugt können die erste und zweite Glasübergangstemperatur derart eingestellt sein, dass bei einem üblichen Löt- und Abkühlungsvorgang die Erstarrung des Abdeckelements und des Vergusses im Wesentlichen gleichzeitig stattfindet.

In der erfinderischen Ausführungsform liegt die erste Glasübergangstemperatur in einem Bereich zwischen 120°C und 150°C, wobei die Grenzen mit eingeschlossen sein können.

In der erfinderischen Ausführungsform liegt die zweite Glasübergangstemperatur in einem Bereich zwischen 80°C und 120°C und bevorzugt zwischen 80°C und 110°C, wobei die Grenzen mit eingeschlossen sein können.

Bei dem hier beschriebenen elektronischen Bauelement kann durch die Anpassung der ersten und zweiten Glasübergangstemperatur zueinander ein verbessertes thermomechanisches Verhalten während des Lötprozesses, insbesondere für oberflächenmontierbare elektronische Bauelemente, ermöglicht werden. Insbesondere kann es möglich sein, beim Lötvorgang und beim anschließenden Abkühlen den mechanischen Stress auf den Halbleiterchip zu reduzieren und damit eine Delamination des Halbleiterchips von einem Leiterrahmen beziehungsweise vom Gehäusekörper zu verhindern. Dies kann insbesondere dadurch möglich sein, dass beim Lötvorgang und beim anschließenden Abkühlvorgang geringere Zugkräfte innerhalb des Bauelements und dabei insbesondere innerhalb der Vertiefung des Gehäusekörpers auf den Chip wirken so dass das Abheben des Halbleiterchips verhindert werden kann.

Weitere Vorteile und vorteilhafte Ausführungsformen und Weiterbildungen ergeben sich aus den im Folgenden in Verbindung mit den Figuren 1 bis 4 beschriebenen Ausführungsformen.

Es zeigen:
Figuren 1 bis 3 schematische Darstellungen von elektronischen Bauelementen gemäß verschiedenen Ausführungsbeispiele und
Figur 4 eine schematische Darstellung eines Abkühlvorgangs nach einem Lötprozess eines elektronischen Bauelements gemäß einem weiteren Ausführungsbeispiel.

In den Ausführungsbeispielen und Figuren können gleiche oder gleich wirkende Bestandteile jeweils mit den gleichen Bezugszeichen versehen sein. Die dargestellten Elemente und deren Größenverhältnisse untereinander sind grundsätzlich nicht als maßstabsgerecht anzusehen, vielmehr können einzelne Elemente, wie zum Beispiel Schichten, Bauteile, Bauelemente und Bereiche, zur besseren Darstellbarkeit und/oder zum besseren Verständnis übertrieben dick oder groß dimensioniert dargestellt sein.

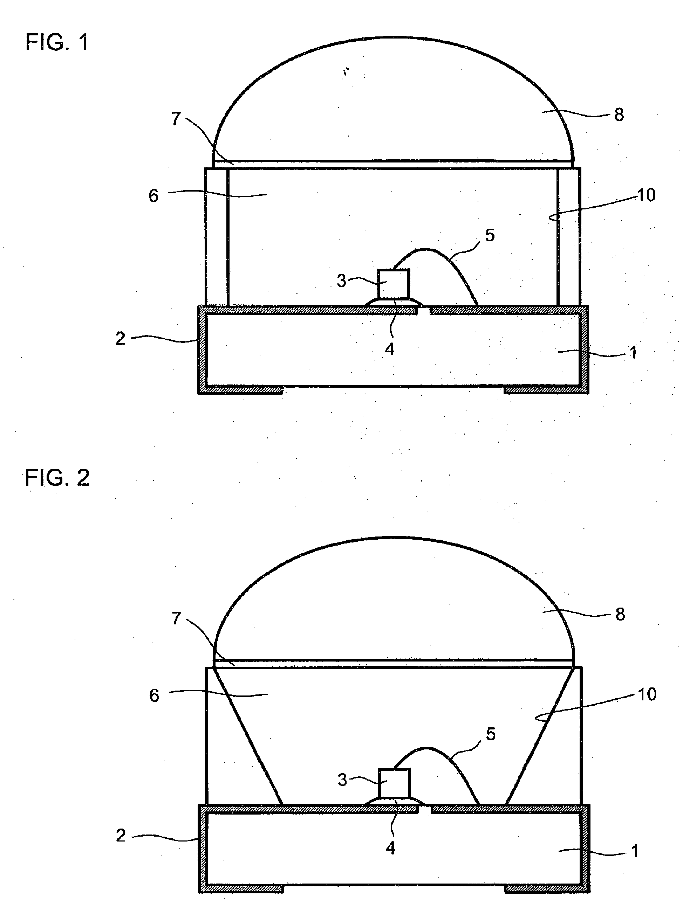

In Figur 1 ist ein Ausführungsbeispiel für ein elektronisches Bauelement gezeigt, das einen Gehäusekörper 1 aufweist. Der Gehäusekörper 1 weist eine Vertiefung 10 auf, in der ein Halbleiterchip 3 angeordnet ist. Rein beispielhaft ist in vorliegendem Ausführungsbeispiel sowie auch in den folgenden Ausführungsbeispielen das jeweils gezeigte elektronische Bauelement als optoelektronisches Bauelement ausgeführt, das einen optoelektronischen Halbleiterchip und insbesondere einen Licht emittierenden Halbleiterchip aufweist.

Der Gehäusekörper 1 weist im vorliegenden Ausführungsbeispiel ein Thermoplast auf, beispielsweise Polyphthalamid (PPA), und ist mittels eines Formprozesses, beispielsweise Spritzgießen, ausgeformt. Bei der Herstellung des Gehäusekörpers 1 wird ein Leiterrahmen 2 bereitgestellt, der mit dem Material des Gehäusekörpers 1 umformt wird. Dabei sind der Gehäusekörper 1 und der Leiterrahmen 2 derart ausgeführt, dass, wie in Figur 1 gezeigt, das elektronische Bauelement oberflächenmontierbar ist.

Der Halbleiterchip 3 ist mittels eines Verbindungsmaterials 4, im gezeigten Ausführungsbeispiel mittels eines elektrisch leitenden Klebstoffs, auf dem Leiterrahmen 2 und damit auf dem Gehäusekörper 1 in der Vertiefung 10 befestigt. Eine Oberseite des Halbleiterchips 3 ist mittels eines Bonddrahts 5, beispielsweise eines Golddrahts, am Leiterrahmen 2 elektrisch angeschlossen.

Alternativ zur hier beschriebenen Ausführung des Gehäusekörpers 1, beispielsweise des Materials des Gehäusekörpers 1, gegebenenfalls des Leiterrahmens 2 sowie des Halbleiterchips 3 können diese Elemente auch andere Materialien, Geometrien, Anordnungen und Ausführungen aufweisen.

In der Vertiefung 10 des Gehäusekörpers 1 ist ein Verguss 6 aus einem ersten Kunststoffmaterial angeordnet, in dem der Halbleiterchip 3 eingebettet ist. Im gezeigten Ausführungsbeispiel füllt der Verguss 6 dabei die Vertiefung 10 komplett aus. Alternativ dazu kann es auch möglich sein, dass der Verguss 6 die Vertiefung 10 nur teilweise füllt, also dass der Verguss 6 nicht bis zum oberen Rand der Vertiefung 10 heranreicht.

Über der Vertiefung 10 ist ein Abdeckelement 8 aus einem zweiten Kunststoffmaterial angeordnet. Das Abdeckelement 8 ist dabei im gezeigten Ausführungsbeispiel als Linse ausgeführt, die vor dem Aufbringen auf den Verguss 6 vorgeformt und vorgefertigt ist und die mittels eines Klebstoffs 7 auf dem Verguss angeordnet und an diesem befestigt ist. Vor dem Aufbringen des Abdeckelements 8 wird auch der Verguss 6 ausgehärtet.

Das erste Kunststoffmaterial des Vergusses 6 sowie das zweite Kunststoffmaterial des Abdeckelements 8 sind jeweils aus einem transparenten Duroplast gefertigt, im gezeigten Ausführungsbeispiel insbesondere jeweils aus einem Epoxidharz. Dabei weist das erste Kunststoffmaterial eine erste Glasübergangstemperatur auf, die in einem Bereich zwischen 120°C und 150°C liegt, während das zweite Kunststoffmaterial eine zweite Glasübergangstemperatur aufweist, die kleiner als die erste Glasübergangstemperatur ist. Insbesondere liegt im gezeigten Ausführungsbeispiel die zweite Glasübergangstemperatur in einem Bereich zwischen 80°C und 110°C.

Die unterschiedlichen Glasübergangstemperaturen des ersten und zweiten Kunststoffmaterials können durch Zusätze zum jeweiligen Epoxidharz und/oder durch unterschiedliche Vernetzungsgrade der Materialien beim jeweiligen Aushärten erreicht werden.

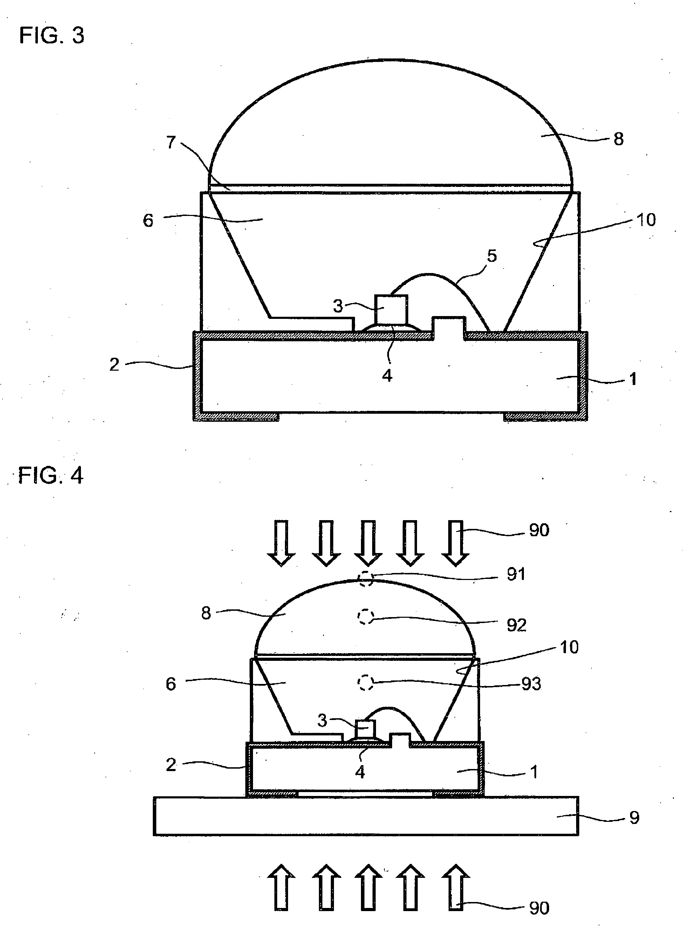

Insbesondere kann es auch vorteilhaft sein, wenn der Klebstoff 7 gleiche Eigenschaften, insbesondere eine gleiche Glasübergangstemperatur, wie das Abdeckelement 8 aufweist. Dazu kann als Klebstoff 7 beispielsweise das zweite Kunststoffmaterial des Abdeckelements 8 aufgebracht werden. In den Figuren 2 und 3 sind weitere Ausführungsbeispiele für elektronische Bauelemente gezeigt, die im Vergleich zum Ausführungsbeispiel gemäß der Figur 1 eine als Reflektor ausgeformte Vertiefung 10 im Gehäusekörper 1 aufweisen. Dadurch kann insbesondere bei einem elektronischen Bauelement, das einen Licht emittierenden Halbleiterchip 3 aufweist, eine Erhöhung der Abstrahlung des im Halbleiterchip 3 emittierten Lichtes in Vorwärtsrichtung ermöglicht werden.

Der Gehäusekörper des elektronischen Bauelements gemäß dem Ausführungsbeispiel in Figur 3 ist weiterhin derart ausgeführt, dass die Vertiefung 10, insbesondere die Bodenfläche der Vertiefung 10, bis auf Montagebeziehungsweise Anschlussbereiche für den Halbleiterchip 3 und dem Bonddraht 5 vom Gehäusekörpermaterial bedeckt sind, um die Reflektivität der als Reflektor ausgeformten Vertiefung 10 noch weiter zu erhöhen.

In Figur 4 ist rein beispielhaft das elektronische Bauelement gemäß dem Ausführungsbeispiel aus Figur 3 gezeigt, das mittels eines rein beispielhaft mittels eines üblichen Lötprozesses auf einer Platine beziehungsweise einer Leiterplatte 9 aufgelötet wird.

Hierzu werden das Bauelement und die Leiterplatte 9 auf eine Maximaltemperatur (Peaktemperatur) von üblicherweise größer oder gleich 240°C und kleiner oder gleich 270°C und typischerweise von 260°C geheizt, bei der ein zwischen der Leiterplatte 9 und dem Leiterrahmen 2 des elektronischen Bauelements angeordnetes Lötmittel schmilzt und somit eine Montage und Befestigung des Bauelements auf der Leiterplatte 9 ermöglicht. Anschließend wird das Bauelement auf 165°C abgekühlt.

Von der Temperatur von 165°C an wird das Bauelement direkt auf Raumtemperatur mit einer Abkühlrate von üblicherweise 6 Kelvin pro Sekunden abgekühlt. Dabei wird das Bauelement auf der Leiterplatte 9 von der Ober- und Unterseite mit Kühlluft angeblasen, wie mittels der Pfeile 90 angedeutet ist. In diesem Zeitbereich erfahren die einzelnen Elemente des elektronischen Bauelements deutliche Temperaturunterschiede. Während auf der Oberfläche des Bauelements im mit 91 markierten Bereich aufgrund der aktiven Kühlung sehr rasch die Temperatur der Abkühlluft erreicht wird, befinden sich die inneren Komponenten, etwa im Bereich 93, wie etwa der Verguss 6 aber auch der Halbleiterchip 3 und das Verbindungsmaterial 4, noch bei einer höheren Temperatur. Beim Abkühlen erfahren die Kunststoffmaterialien jedoch jeweils eine Schrumpfung. Das erste und das zweite Kunststoffmaterial, die im gezeigten Ausführungsbeispiel ein Epoxidharz aufweisen, erfahren jeweils einen starken Schrumpf oberhalb der Glasübergangstemperatur, während unterhalb der Glasübergangstemperatur die temperaturbedingte Ausdehnung des jeweiligen Materials um Größenordnungen geringer ist.

Weiterhin ändert sich beim Übergang der Glasübergangstemperatur der Elastizitätsmodul des jeweiligen Kunststoffmaterials stark. Unterhalb der Glasübergangstemperatur ist der Elastizitätsmodul hoch, bei Epoxidharzen beispielsweise größer als 1 GPa, was sich in einer starren Struktur des Materials widerspiegelt. Oberhalb der Glasübergangstemperatur erweichen die Epoxidharze und der Elastizitätsmodul nimmt ab, typischerweise auf Werte von weniger als 1 MPa. Weiterhin ist beim Übergang beziehungsweise dem Unterschreiten der Glasübergangstemperatur die Änderung der jeweiligen Ausdehnungskoeffizienten nicht zu vernachlässigen. Epoxidharze weisen typischerweise unterhalb der Glasübergangstemperatur einen thermischen Ausdehnungskoeffizienten von 60 bis 70 ppm/K auf, während der Ausdehnungskoeffizient oberhalb der Glasübergangstemperatur etwa 160 bis 170 ppm/K beträgt.

Zur Verdeutlichung des vorteilhaften Effekts des hier beschriebenen elektronischen Bauelements wird im Folgenden zuerst die Auswirkung des Abkühlvorgangs auf ein herkömmliches Bauelement mit einem Verguss oder einem Abdeckelement beschrieben, die jeweils Materialien mit etwa der gleichen Glasübergangstemperatur aufweisen. Hierbei wird rein beispielhaft davon ausgegangen, dass die jeweilige Glasübergangstemperatur etwa bei 130°C liegt.

Beim Aufheizvorgang bis zur Peaktemperatur im Lötprozess dehnen sich die jeweiligen Materialien, also das Material des Gehäusekörpers, des Vergusses und des Abdeckelements, stark gegenüber dem Zustand bei Raumtemperatur aus. In der Abkühlphase schrumpfen die Materialien wiederum. Dabei kann es zu einem Fall kommen, bei dem das Abdeckelement schon eine Temperatur unterhalb seiner Glasübergangstemperatur aufweist, während das Vergussmaterial noch über der Glasübergangstemperatur liegt. Dies kann dazu führen, dass die Oberfläche des Abdeckelements schon erstarrt ist und einen hohen Elastizitätsmodul aufweist, während das Innere des Abdeckelements sowie das Vergussmaterial noch oberhalb der Glasübergangstemperatur liegen. Das bedeutet, dass die Oberfläche des Abdeckelements bereits zu einem Zeitpunkt erstarrt ist, bei dem das Abdeckelement gegenüber seinem Zustand bei Raumtemperatur noch ein höheres Volumen aufweist. Dadurch tritt der Effekt auf, dass sich das Material des Abdeckelements durch die weitere Abkühlung zusammenzieht, also schrumpft, und versucht, sein Volumen zu reduzieren. Dadurch, dass die Oberfläche des Abdeckelements schon erstarrt ist und eine feste Form eingenommen hat, verändert sich der Schrumpfungsschwerpunkt des gesamten Systems aus Verguss, Kleber und Abdeckelement und wird in Richtung der Oberfläche des Abdeckelements verlagert. Das bedeutet weiterhin gleichzeitig, dass das jeweilige Material von den zur Oberfläche des Abdeckelements gegenüberliegenden Verbindungsflächen zwischen dem Verguss und dem Leiterrahmen, dem Verguss und dem Halbleiterchip und dem Verguss und dem Chipkleber eine Zugspannung aufgebaut wird. Diese Zugspannung übersteigt oft die Adhäsionskräfte des Vergusses am Leiterrahmen, so dass hier eine Delamination des Vergussmaterials beobachtet werden kann. Wenn die Zugkräfte höher sind als die Adhäsionskräfte zwischen dem Halbleiterchip und dem Chipkleber oder dem Chipkleber und dem Leiterrahmen, führt dies zur Delamination des Halbleiterchips vom Leiterrahmen, wodurch ein offener elektrischer Kontakt im Bauelement entsteht, der zum Ausfall des Bauelements führt.

Im Gegensatz zu diesem, bei bekannten Bauelementen auftretenden Effekt kann das Abheben des Halbleiterchips 3 während oder nach dem Lötvorgang und dem Abkühlvorgang dadurch vermieden werden, dass dem thermischen Ungleichgewicht durch eine geeignete Auswahl des ersten und zweiten Kunststoffmaterials und der entsprechenden Glasübergangstemperaturen entgegengewirkt wird. Dadurch, dass das zweite Kunststoffmaterial die zweite Glasübergangstemperatur aufweist, die kleiner als die erste Glasübergangstemperatur des ersten Kunststoffmaterials ist, kann erreicht werden, dass der Verguss 6 die erste Glasübergangstemperatur früher oder gleichzeitig dann unterschreitet, wenn auch das Abdeckelement 8 die zweite Glasübergangstemperatur unterschreitet, wodurch vom Abdeckelement 8 geringerer mechanischer Stress auf den Verguss 6 und somit auf den Halbleiterchip 3 ausgeübt wird.

Geht man vom bekannten Bauelement aus, bei dem die Glasübergangstemperatur des Abdeckelements und des Vergusses in etwa gleich sind, so herrschen in den in Figur 4 gezeigten Bereichen '91, 92 und 93 während des Abkühlvorgangs unterschiedliche Temperaturen, wobei die Temperatur im Bereich 91 kleiner ist als die Temperatur im Bereich 92, die wiederum kleiner ist als die Temperatur im Bereich 93. Fällt die Temperatur im Bereich 91 unter die Glasübergangstemperatur, also beispielsweise bei einer Glasübergangstemperatur von 130°C unter diese Temperatur, ist die Oberseite des Abdeckelements bereits erstarrt, während wie oben beschrieben in den Bereichen 92 und 93 das Abdeckelement beziehungsweise der Verguss noch eine Temperatur über der Glasübergangstemperatur aufweisen können und damit noch weiter schrumpfen können.

Beim hier beschriebenen elektronischen Bauelement mit einer zweiten Glasübergangstemperatur, die kleiner ist als die erste Glasübergangstemperatur, wird im Folgenden rein beispielhaft von einer ersten Glasübergangstemperatur des Vergusses 6 von etwa 130°C und einer zweiten Glasübergangstemperatur des Abdeckelements 8 von etwa 100°C ausgegangen. Solange die Temperatur im Bereich 91 höher als 100°C ist, ist die Oberfläche des Abdeckelements 8 noch nicht erstarrt. Erst wenn die Temperatur im Bereich 91 unter die zweite Glasübergangstemperatur von 100°C fällt, ist die Oberfläche des Abdeckelements 8 erstarrt. Solange sich die Temperatur im Bereich 92, also im Inneren des Abdeckelements 8, noch über 100°C befindet, schrumpft das zweite Kunststoffmaterial des Abdeckelements 8 in diesem Bereich noch. Befindet sich das erste Kunststoffmaterial im Bereich 93 unterhalb einer Temperatur von 130°C aber noch oberhalb einer Temperatur von 100°C, so ist aufgrund der ersten Übergangstemperatur von 130°C der Verguss 6, also das erste Kunststoffmaterial, bereits erstarrt. Nimmt man beispielsweise an, dass sowohl im Bereich 92 als auch im Bereich 93 beispielsweise eine Temperatur von 120°C vorherrscht, ist der Verguss 6 bereits erstarrt, während sich das Abdeckelement 8 noch oberhalb der zweiten Glasübergangstemperatur befindet. Sogar wenn das Abdeckelement 8 im Bereich 92 noch weiter schrumpft, können so die Kräfte erheblich reduziert werden, die auf den Halbleiterchip 3 beziehungsweise auf die jeweiligen Grenzflächen zwischen dem Verguss 6, dem Halbleiterchip 3, dem Verbindungsmaterial 4, dem Leiterrahmen 2 und dem Gehäusematerial 1 wirken. Dadurch ist es möglich, dem thermischen Ungleichgewicht beim Abkühlen nach einem Lötvorgang entgegenzuwirken und so die Delamination des Halbleiterchips 3 zu vermeiden.

## Patentansprüche

1. Elektronisches Bauelement mit einem Gehäusekörper (1), der einen Halbleiterchip (3) in einer Vertiefung (10) aufweist, wobei
- der Halbleiterchip (3) in der Vertiefung in einen Verguss (6) aus einem ersten Kunststoffmaterial mit einer ersten Glasübergangstemperatur eingebettet ist,
- über der Vertiefung (10) ein Abdeckelement (8) aus einem zweiten Kunststoffmaterial mit einer zweiten Glasübergangstemperatur angeordnet ist und
- die zweite Glasübergangstemperatur kleiner als die erste Glasübergangstemperatur ist, wobei die erste Glasübergangstemperatur in einem Bereich zwischen 120°C und 150°C liegt, **dadurch gekennzeichnet, dass** die zweite Glasübergangstemperatur in einem Bereich zwischen 80°C und 120°C liegt.

2. Bauelement nach Anspruch 1, wobei das erste und das zweite Kunststoffmaterial jeweils ein Duroplast aufweisen.

3. Bauelement nach Anspruch 2, wobei das erste und zweite Kunststoffmaterial jeweils ein Epoxidharz aufweisen.

4. Bauelement nach einem der vorherigen Ansprüche, wobei das Abdeckelement (8) mittels eines Klebstoffs (7) auf dem Verguss (6) angeordnet ist.

5. Bauelement nach dem vorherigen Anspruch, wobei der Klebstoff (7) und das Abdeckelement (8) eine gleiche Glasübergangstemperatur aufweisen.

6. Bauelement nach einem der vorherigen Ansprüche, weiterhin aufweisend einen Leiterrahmen (2), der in den Gehäusekörper (1) eingebettet ist und auf dem der Halbleiterchip (3) mittels eines Verbindungsmaterials (4) montiert ist.

7. Bauelement nach einem der vorherigen Ansprüche, wobei der Gehäusekörper (1) ein Thermoplast aufweist.

8. Bauelement nach Anspruch 7, wobei das Thermoplast Polyphthalamid aufweist.

9. Bauelement nach einem der vorherigen Ansprüche, wobei der Gehäusekörper (1) oberflächenmontierbar ist.

10. Bauelement nach einem der vorherigen Ansprüche, wobei der Halbleiterchip (3) ein optoelektronischer Halbleiterchip ist.

11. Bauelement nach Anspruch 10, wobei der optoelektronische Halbleiterchip (3) ein Licht emittierender Halbleiterchip ist.

## Claims

1. Electronic device comprising a housing body (1), which has a semiconductor chip (3) in a cavity (10), wherein
- the semiconductor chip (3) in the cavity is embedded into a potting (6) composed of a first plastic material having a first glass transition temperature,
- a cover element (8) composed of a second plastic material having a second glass transition temperature is arranged above the cavity (10), and
- the second glass transition temperature is lower than the first glass transition temperature, wherein the first glass transition temperature is in a range of between 120°C and 150°C, **characterized in that** the second glass transition temperature is in a range of between 80°C and 120°C.

2. Device according to Claim 1, wherein the first and second plastic materials in each case comprise a thermosetting plastic.

3. Device according to Claim 2, wherein the first and second plastic materials in each case comprise an epoxy resin.

4. Device according to any of the preceding claims, wherein the cover element (8) is arranged on the potting (6) by means of an adhesive (7).

5. Device according to the preceding claim, wherein the adhesive (7) and the cover element (8) have an equal glass transition temperature.

6. Device according to any of the preceding claims, furthermore comprising a leadframe (2), which is embedded into the housing body (1) and on which the semiconductor chip (3) is mounted by means of a connecting material (4).

7. Device according to any of the preceding claims, wherein the housing body (1) comprises a thermoplastic.

8. Device according to Claim 7, wherein the thermoplastic comprises polyphthalamide.

9. Device according to any of the preceding claims, wherein the housing body (1) is surface-mountable.

10. Device according to any of the preceding claims, wherein the semiconductor chip (3) is an optoelectronic semiconductor chip.

11. Device according to Claim 10, wherein the optoelectronic semiconductor chip (3) is a light-emitting semiconductor chip.

## Revendications

1. Composant électronique avec un corps de boîtier (1) qui comporte une puce semi-conductrice (3) dans un creux (10), pour lequel
- la puce semi-conductrice (3) est insérée dans le creux dans une masse de scellement (6) dans une première matière plastique avec une première température de transition vitreuse,
- un élément de recouvrement (8) dans une deuxième matière plastique avec une deuxième température de transition vitreuse est disposé sur le creux (10) et
- la deuxième température de transition vitreuse est inférieure à la première température de transition vitreuse, pour lequel la première température de transition vitreuse se situe dans une gamme entre 120 °C et 150 °C, **caractérisé en ce que** la deuxième température de transition vitreuse se situe dans une gamme entre 80 °C et 120 °C.

2. Composant selon la revendication 1 pour lequel la première et la deuxième matière plastique comportent respectivement un plastique thermodurcissable.

3. Composant selon la revendication 2 pour lequel la première et la deuxième matière plastique comportent respectivement une résine époxy.

4. Composant selon l'une quelconque des revendications précédentes pour lequel l'élément de recouvrement (8) est disposé sur la masse de scellement (6) au moyen d'un adhésif (7).

5. Composant selon la revendication précédente pour lequel l'adhésif (7) et l'élément de recouvrement (8) présentent une température de transition vitreuse analogue.

6. Composant selon l'une quelconque des revendications précédentes comportant en plus un cadre conducteur (2) qui est inséré dans le corps de boîtier (1) et sur lequel la puce semi-conductrice (3) est montée au moyen d'un matériau de liaison (4).

7. Composant selon l'une quelconque des revendications précédentes pour lequel le corps de boîtier (1) comporte un thermoplastique.

8. Composant selon la revendication 7 pour lequel le thermoplastique comporte du polyphtalamide.

9. Composant selon l'une quelconque des revendications précédentes pour lequel le corps de boîtier (1) peut être monté en surface.

10. Composant selon l'une quelconque des revendications précédentes pour lequel la puce semi-conductrice (3) est une puce semi-conductrice optoélectronique.

11. Composant selon la revendication 10 pour lequel la puce semi-conductrice optoélectronique (3) est une puce semi-conductrice électroluminescente.
